# EUROPEAN PATENT APPLICATION

(11) **EP 4 842 146 A1**
(43) Date of publication of application: **18.11.2026**
(21) Application number: 25739112.8
(22) Date of filing: 09.01.2025
(51) Int. Cl.: H05K 1/11, H05K 3/42, H05K 1/09, H01L 23/12, H05K 3/02

(54) **CIRCUIT BOARD AND SEMICONDUCTOR PACKAGE COMPRISING SAME**

(30) Priority: 10.01.2024 KR 20240004006; 19.11.2024 KR 20240165690
(71) Applicant: LG Innotek Co., Ltd., Seoul 07796 (KR)
(72) Inventor: YOO, Jae Hyoun, Seoul 07796 (KR)
(74) Representative: Plasseraud IP
(86) International application number: PCT/KR2025/000564
(87) International publication number: WO 2025/150952

(57) **Abstract**

A circuit board according to an embodiment may include an insulating layer including a through hole penetrating an upper surface and a lower surface, a circuit layer disposed on the upper surface of the insulating layer, and a metal layer disposed between the circuit layer and the upper surface of the insulating layer.

The circuit layer may include a wiring portion disposed on the upper surface of the insulating layer and a via portion extending from the wiring portion, disposed inside the through hole of the insulating layer, and overlapping the insulating layer in a horizontal direction.

The metal layer may include an extension portion extending into the through hole, vertically overlapping at least a part of the via portion, and not contacting an inner wall of the through hole.

## Description

### Technical Field

An embodiment relates to a circuit board and a semiconductor package including the same.

### Background Art

A circuit board may include an insulating layer and a circuit layer disposed on the insulating layer, and may refer to a board on which a semiconductor device is mounted. For example, the circuit board may refer to one in which a mounting position of each semiconductor device is predetermined in order to mount at least one semiconductor device, and a circuit layer connected to the semiconductor device is disposed on the insulating layer. The circuit layer may include a through electrode (or via) and a circuit pattern layer (or metal wiring). The semiconductor device may be mounted on the circuit board and may transmit and receive signals through the circuit layer.

Meanwhile, in a conventional circuit board, during a process of forming a through electrode, there is a process of forming a through hole in a copper clad laminate (CCL) in which a copper foil is laminated on an insulating layer such as prepreg (PPG), epoxy, or polyimide, and forming the through electrode in the through hole. For example, in the conventional technology, a through hole is formed through a laser drill process using CO₂ in a state in which the copper foil is bonded, and a through electrode is formed by a plating process.

However, when the copper foil of the copper clad laminate is thick, for example, about 6 micrometers or more, an energy absorption rate is low, about 5%, and thus CO₂ laser drilling is difficult. Accordingly, in the conventional technology, the copper foil at a position where the through hole is to be formed is removed by etching through a photo process, for example, a DES (Developing-Etching-Striping) process, and then laser drilling is performed on the exposed insulating layer.

Accordingly, in the conventional technology, since the process of forming a circuit layer of the copper clad laminate requires a photo process for the copper foil, a process production delivery L/T (Lead Time) increases and manufacturing cost also increases.

In addition, in the conventional technology, since the copper foil of the copper clad laminate is removed by etching, a side surface of the copper foil at an entrance of the through hole is smooth as if cut with a knife, and thus processability of plating in a subsequent plating process may be deteriorated.

### Disclosure

### Technical Problem

One of technical problems of an embodiment is to provide a circuit board and a semiconductor package including the same, capable of partially removing a copper foil without a photo process in a process of forming a circuit layer using a copper clad laminate.

In addition, one of technical problems of an embodiment is to improve plating processability in a plating process performed after the copper foil of the copper clad laminate is partially removed.

The technical problems of the embodiment are not limited to those described in this section, and include those that may be understood from the description of the invention.

### Technical Solution

A circuit board according to an embodiment may include an insulating layer including a through hole penetrating an upper surface and a lower surface, a circuit layer disposed on the upper surface of the insulating layer, and a metal layer disposed between the circuit layer and the upper surface of the insulating layer.

The circuit layer may include a wiring portion disposed on the upper surface of the insulating layer and a via portion extending from the wiring portion, disposed inside the through hole of the insulating layer, and overlapping the insulating layer in a horizontal direction.

The metal layer may include an extension portion extending into the through hole, vertically overlapping at least a part of the via portion, and not contacting an inner wall of the through hole.

A side surface roughness of the extension portion of the metal layer may be different from a roughness of an inner wall of the through hole formed in the insulating layer.

A length by which the extension portion of the metal layer extends into the through hole may be less than 1/2 of a horizontal width of an upper portion of the through hole provided in the insulating layer.

An upper surface of the metal layer contacting the wiring portion may include a surface treatment region.

The metal layer may be disposed at a height equal to or higher than the through hole of the insulating layer.

A thickness of the wiring portion may be thicker than a thickness of the metal layer.

An embodiment may further include a second metal layer disposed on a lower surface of the insulating layer as the circuit layer.

The second metal layer may vertically overlap the wiring portion and the via portion.

A lower surface of the second metal layer may include a surface treatment region.

A side inclination of the extension portion of the metal layer may correspond to an inclination of the inner wall of the through hole formed in the insulating layer.

A semiconductor package according to an embodiment may include any one of the circuit boards.

### Advantageous Effects

According to a circuit board and a semiconductor package including the same according to an embodiment, there is a feature that a through hole may be formed in an insulating layer while partially removing a copper foil without a photo process in a process of forming a circuit layer using a copper clad laminate. Accordingly, since a photo process conventionally required for partially removing the copper foil in forming a through electrode of the copper clad laminate is omitted, a process production delivery L/T (Lead Time) may be shortened and manufacturing cost may be reduced.

In addition, according to an embodiment, by improving plating processability in a plating process performed after forming a through hole in a copper clad laminate, physical reliability and electrical reliability of a through electrode and a circuit pattern layer (metal wiring) can be improved.

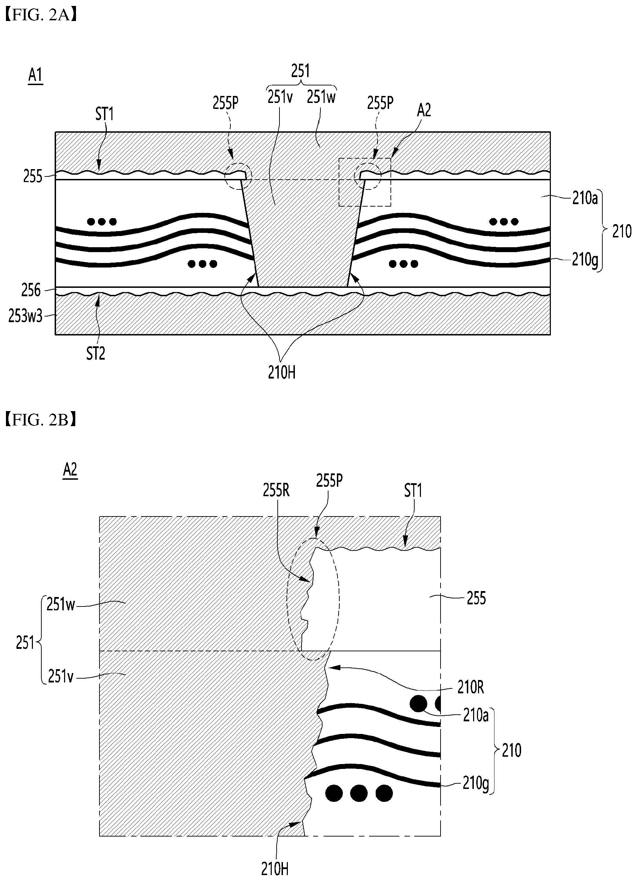

For example, referring to FIG. 2A and FIG. 2B, since a first metal layer (255) includes an extension portion (255P) vertically overlapping at least a part of a first via portion (251v) and not contacting an inner wall of a first through hole (210H), physical reliability of a circuit layer including the first via portion (251v) can be improved.

In addition, since the extension portion (255P) of the first metal layer includes a side surface roughness (255R), plating processability in a plating process can be improved, and physical reliability and electrical reliability of a through electrode and a wiring portion can be improved.

The technical effects of the embodiment are not limited to those described in this section, and include those that may be understood from the description of the invention.

### Description of Drawings

FIG. 1 is a cross-sectional view of a circuit board (200) according to an embodiment.
FIG. 2A is an enlarged view of a first region (A1) of the circuit board (200) according to the embodiment illustrated in FIG. 1.
FIG. 2B is an enlarged view of a second region (A2) of the first region (A1) of the circuit board (200) according to the embodiment illustrated in FIG. 2A.
FIG. 2C is a microscopic image of a region corresponding to the first region (A1) of the circuit board (200) according to an embodiment.
FIGS. 3A to 3D are process views of a manufacturing process of the first region (A1) of the circuit board (200) according to the embodiment illustrated in FIG. 2A.
FIG. 4 is a cross-sectional view illustrating a semiconductor package according to a first embodiment.
FIG. 5 is a cross-sectional view illustrating a semiconductor package according to a second embodiment.

### Mode for Invention

Hereinafter, preferred embodiments of the present invention will be described in detail with reference to the accompanying drawings. However, the technical idea of the present invention is not limited to some embodiments described, but may be implemented in various different forms, and within the scope of the technical idea of the present invention, one or more components among the embodiments may be selectively combined and substituted.

In addition, terms used in the embodiments of the present invention are for describing the embodiments and are not intended to limit the present invention. In the present specification, a singular form may include a plural form unless otherwise specifically stated in a phrase, and when described as "at least one (or one or more) of A, B, and C," it may include one or more of all combinations that may be combined with A, B, and C.

In addition, in describing components of the embodiments of the present invention, terms such as first, second, A, B, (a), and (b) may be used. These terms are only for distinguishing the components from other components, and do not limit the nature, order, or sequence of the components by the terms.

In addition, when it is described that one component is 'connected', 'coupled', or 'joined' to another component, it includes not only a case where the one component is directly connected, coupled, or joined to the other component, but also a case where the one component is 'connected', 'coupled', or 'joined' to the other component by another component interposed therebetween.

In addition, when it is described that each component is formed or disposed "on (above) or under (below)" another component, "on (above) or under (below)" includes not only a case where two components are in direct contact with each other, but also a case where one or more other components are formed or disposed between the two components. In addition, when expressed as "on (above) or under (below)," it may include not only an upward direction but also a downward direction based on one component.

### (Embodiment)

Hereinafter, a circuit board and a semiconductor package according to an embodiment will be described in detail. Here, the circuit board may refer to a board before an electronic device is mounted. In addition, the circuit board may refer to an auxiliary board (for example, an interposer) connected to another board on which an electronic device is mounted. In addition, the semiconductor package may refer to a package in a state in which an electronic device is mounted on the circuit board. In this case, a product group to which the circuit board of the embodiment is applied may include FC-BGA (Flip Chip-Ball Grid Array) or FC-CSP (Flip Chip-Chip Scale Package), but is not limited thereto.

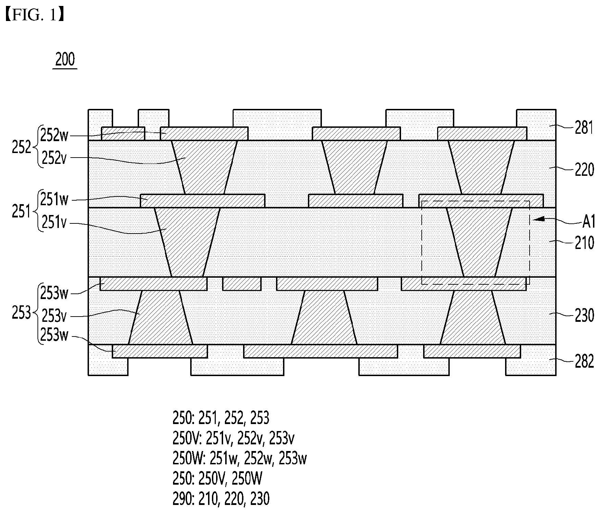

FIG. 1 is a cross-sectional view of a circuit board (200) according to an embodiment.

Referring to FIG. 1, the circuit board (200) of the embodiment includes an insulating layer (290), a circuit layer (250), and a protective layer (280). The insulating layer (290) includes a first insulating layer (210), a second insulating layer (220), and a third insulating layer (230). The circuit layer (250) includes a first circuit layer (251), a second circuit layer (252), and a third circuit layer (253). In addition, the circuit layer (250) includes a via portion (250V) disposed in a through hole of the insulating layer and a wiring portion (250W) disposed on an upper surface or a lower surface of the insulating layer. The via portion (250V) may be referred to as a 'through electrode' or a 'via', and the wiring portion (250W) may be referred to as a 'circuit pattern layer' or a 'metal wiring'.

First, the circuit board (200) of the embodiment includes a single or a plurality of insulating layers (290). For example, the insulating layer (290) of the embodiment includes the first insulating layer (210), the second insulating layer (220), and the third insulating layer (230), but is not limited thereto. For example, the embodiment may have two or fewer layers or four or more layers based on the number of insulating layers.

The circuit board (200) of the embodiment includes an inner insulating layer and an outer insulating layer. The inner insulating layer may refer to an insulating layer positioned at an inner side in a stacked structure of a plurality of insulating layers. The outer insulating layer may refer to an insulating layer positioned at an outer side among the plurality of insulating layers. For example, the first insulating layer (210) may be an inner insulating layer, and the second insulating layer (220) and the third insulating layer (230) may be outer insulating layers.

At least one of the insulating layers (290) of the embodiment may be rigid or flexible. For example, at least one of the insulating layers (290) may include glass or plastic. For example, at least one of the insulating layers (290) may include chemically strengthened or semi-strengthened glass such as soda lime glass or aluminosilicate glass. In addition, the insulating layer (210) may include reinforced or flexible plastic such as polyimide (PI), polyethylene terephthalate (PET), propylene glycol (PPG), or polycarbonate (PC), or may include sapphire.

In addition, at least one of the insulating layers (290) may include an optically isotropic film. For example, at least one of the insulating layers (290) may include COC (Cyclic Olefin Copolymer), COP (Cyclic Olefin Polymer), optically isotropic polycarbonate (PC), or optically isotropic polymethyl methacrylate (PMMA).

In addition, at least one of the insulating layers (290) may be formed of a material including an inorganic filler and an insulating resin. For example, at least one of the insulating layers (290) may use ABF (Ajinomoto Build-up Film), FR-4, BT (Bismaleimide Triazine), or PID (Photo Imageable Dielectric resin).

In addition, at least one of the insulating layers (290) may include prepreg, and through this, may have a strength equal to or greater than a predetermined level capable of improving warpage characteristics of the circuit board. The prepreg constituting the insulating layer (290) may have a structure in which a glass fiber layer in the form of a fabric sheet such as glass fabric is impregnated with epoxy resin. In this case, in the embodiment, the first insulating layer (210), the second insulating layer (220), and the third insulating layer (230) may all be composed of prepreg, or alternatively, the second insulating layer (220) and/or the third insulating layer (230) excluding the first insulating layer (210) may be composed of prepreg.

Next, the circuit board (200) of the embodiment includes a circuit layer (250). The circuit layer (250) includes a via portion (250V) and a wiring portion (250W).

The circuit layer (250) includes a single or a plurality of circuit layers. For example, the circuit layer (250) includes first to third circuit layers (251, 252, 253). For example, the circuit layer (250) includes the first circuit layer (251) disposed on the first insulating layer (210), includes the second circuit layer (252) disposed on the second insulating layer (220), and includes the third circuit layer (253) disposed on the third insulating layer (230).

The circuit layer (250) includes a via portion (250V) penetrating the insulating layer and a wiring portion (250W) disposed on an upper surface or a lower surface of the insulating layer. The via portion (250V) includes first to third via portions (251v, 252v, 253v) penetrating the first insulating layer (210), the second insulating layer (220), and the third insulating layer (230). The wiring portion (250W) includes first to third wiring portions (251w, 252w, 253w) disposed on surfaces of the first insulating layer (210), the second insulating layer (220), and the third insulating layer (230).

The first circuit layer (251) includes a first via portion (251v) and a first wiring portion (251w). In addition, the second circuit layer (252) includes a second via portion (252v) and a second wiring portion (252w). In addition, the third circuit layer (253) includes a third via portion (253v) and a third wiring portion (253w). The third wiring portion (253w) may be respectively disposed on an upper side and a lower side of the third via portion (253v).

The via portion (250V) of the embodiment includes first to third via portions (251v, 252v, 253v) disposed in through holes penetrating the first insulating layer (210), the second insulating layer (220), and the third insulating layer (230), respectively.

For example, the first via portion (251v) may penetrate the first insulating layer (210) and may connect between the first wiring portion (251w) and the third wiring portion (253w).

For example, the second via portion (252v) may penetrate the second insulating layer (220) and may connect between the first wiring portion (251w) and the second wiring portion (252w).

For example, the third via portion (253v) may penetrate the third insulating layer (230) and may connect between an upper third wiring portion (253w) and a lower third wiring portion (253w).

The first via portion (251v), the second via portion (252v), and the third via portion (253v) may be formed by filling through holes (not shown) penetrating at least one of the first insulating layer (210), the second insulating layer (220), and the third insulating layer (230) with a conductive material.

For example, a metal material forming the via portion (250V) may be one selected from copper (Cu), silver (Ag), tin (Sn), gold (Au), nickel (Ni), and palladium (Pd). The conductive material filling may use at least one method among electroless plating, electroplating, screen printing, sputtering, evaporation, ink-jetting, and dispensing.

At least one of the via portions (250V) may have a different shape from another one. For example, the first via portion (251v) and the second via portion (252v) may have a shape different from that of the third via portion (253v), but are not limited thereto.

Next, the wiring portion (250W) of the embodiment includes first to third wiring portions (251w, 252w, 253w) disposed on surfaces of the first insulating layer (210), the second insulating layer (220), and the third insulating layer (230).

The wiring portion (250W) is wiring for transmitting an electrical signal and may be formed of a metal material having high electrical conductivity. For this purpose, the wiring portion (250W) may be formed of at least one metal material selected from gold (Au), silver (Ag), platinum (Pt), titanium (Ti), tin (Sn), copper (Cu), and zinc (Zn).

The wiring portion (250W) includes a trace and a wiring pad. The trace refers to line-type wiring for transmitting an electrical signal. The wiring pad may refer to a mounting pad on which a component such as a chip is mounted, a core pad or a BGA pad for connection with an external board, or an electrode pad connected to a through electrode.

The wiring portion (250W) may be formed of at least one metal material selected from gold (Au), silver (Ag), platinum (Pt), titanium (Ti), tin (Sn), copper (Cu), and zinc (Zn), having excellent bonding strength. The wiring portion (250W) may be manufactured by an additive process, a subtractive process, a semi additive process (SAP), or a modified semi additive process (MSAP), which are manufacturing processes of a printed circuit board.

Next, the circuit board (200) of the embodiment includes a protective layer (280). For example, the protective layer (280) includes a first protective layer (281) disposed on an upper surface of the second insulating layer (220) and a second protective layer (282) disposed on a lower surface of the third insulating layer (230).

The protective layer (280) may be a resist layer. For example, the protective layer (280) may be a solder resist layer including an organic polymer material. For example, the protective layer (280) includes a resin of an epoxy acrylate series. More specifically, the protective layer (280) includes a resin, a curing agent, a photo-initiator, a pigment, a solvent, a filler, an additive, and an acrylic monomer. However, the embodiment is not limited thereto, and the protective layer (280) may be any one of a photo solder resist layer, a coverlay, and a polymer material.

The protective layer (280) may include at least one opening. For example, the first protective layer (281) may include an opening vertically overlapping the second wiring portion (252w). In addition, the second protective layer (282) may include an opening vertically overlapping a lower third wiring portion (253w).

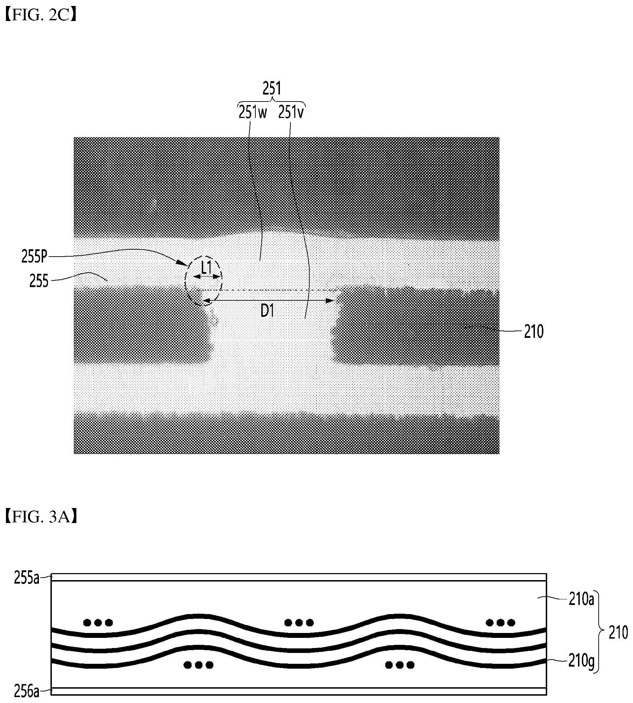

Next, FIG. 2A is an enlarged view of a first region (A1) of the circuit board (200) according to the embodiment illustrated in FIG. 1, FIG. 2B is an enlarged view of a second region (A2) of the first region (A1) of the circuit board (200) according to the embodiment illustrated in FIG. 2A, and FIG. 2C is a microscopic image of a region corresponding to the first region (A1) of the circuit board (200) according to an embodiment.

As described above, one of the technical problems of the embodiment is to provide a circuit board and a semiconductor package including the same, capable of partially removing a copper foil without a photo process in a process of forming a circuit layer using a copper clad laminate. In addition, one of the technical problems of the embodiment is to improve quality of a through electrode in a plating process performed after the copper foil of the copper clad laminate is partially removed.

Hereinafter, technical features of the circuit board (200) according to the embodiment for solving the technical problems of the embodiment will be described in detail based on FIGS. 2A to 2C.

The circuit board (200) of the embodiment includes an insulating layer including a through hole penetrating an upper surface and a lower surface, a circuit layer disposed on the upper surface of the insulating layer, and a first metal layer (255) disposed between the circuit layer and the upper surface of the insulating layer.

For example, referring to FIG. 2, the circuit board (200) of the embodiment includes a first insulating layer (210) including a first through hole (210H) penetrating an upper surface and a lower surface, a first circuit layer (251) disposed on the upper surface of the first insulating layer (210), and a first metal layer (255) disposed between the first circuit layer (251) and the upper surface of the first insulating layer (210). In addition, the circuit board (200) of the embodiment may include a second metal layer (256) disposed on a lower surface of the first insulating layer (210), but is not limited thereto.

The first metal layer (255) or the second metal layer (256) may be a conductive metal, for example, one selected from copper (Cu), silver (Ag), tin (Sn), gold (Au), nickel (Ni), and palladium (Pd), but is not limited thereto.

The first circuit layer (251) includes a first wiring portion (251w) disposed on the upper surface of the first insulating layer (210) and a first via portion (251v) extending from the first wiring portion (251w), disposed inside the first through hole (210H) of the first insulating layer (210), and overlapping the first insulating layer (210) in a horizontal direction.

In this case, the first metal layer (255) includes an extension portion (255P) extending into the first through hole (210H), vertically overlapping at least a part of the first via portion (251v), and not contacting an inner wall of the first through hole (210H).

The first metal layer (255) and the second metal layer (256) respectively disposed on an upper side and a lower side of the first insulating layer (210) may be copper foil, but are not limited thereto.

The first metal layer (255) may have a form in which a region corresponding to the first via portion (251v) is removed, and the second metal layer (256) may have a form in which a region corresponding to the first via portion (251v) is not removed, but is not limited thereto.

A surface of the first metal layer (255) or the second metal layer (256) includes a surface treatment region. For example, an upper surface of the first metal layer (255) includes a first surface treatment region (ST1), and a lower surface of the second metal layer (256) includes a second surface treatment region (ST2).

Next, referring to FIG. 2B, the first metal layer (255) includes an extension portion (255P) extending into the first through hole (210H), vertically overlapping at least a part of the first via portion (251v), and not contacting an inner wall of the first through hole (210H).

In this case, a side surface roughness (255R) of the extension portion (255P) of the first metal layer may be different from a roughness (210R) of a side surface of the first through hole (210H) formed in the first insulating layer (210).

For example, the side surface roughness (255R) of the extension portion (255P) of the first metal layer may be about 1.0 to 1.5 micrometers, and the roughness (210R) of the side surface of the first through hole (210H) formed in the first insulating layer (210) may be about 1.0 to 3.0 micrometers, but is not limited thereto.

According to the embodiment, since the extension portion (255P) of the first metal layer includes the side surface roughness (255R), plating processability in a plating process can be improved, and physical reliability and electrical reliability of a through electrode can be improved.

In addition, since the first metal layer (255) includes the extension portion (255P) vertically overlapping at least a part of the first via portion (251v) and not contacting an inner wall of the first through hole (210H), an anchoring role may be provided, thereby improving physical reliability of a circuit layer including the first via portion (251v) and the first wiring portion (251w).

In the embodiment, a side inclination of the extension portion (255P) of the first metal layer may correspond to an inclination of a side surface of the first through hole (210H) formed in the first insulating layer (210). For example, according to the embodiment, since the through hole is formed in a state in which a copper foil is present without a photo process in a process of forming a circuit layer using a copper clad laminate, the side inclination of the extension portion (255P) of the first metal layer may correspond to the inclination of the side surface of the first through hole (210H) formed in the first insulating layer (210).

Next, referring to FIG. 2C, a first horizontal length (L1) of the extension portion (255P) extending into the first through hole (210H) of the first metal layer (255) may be less than 1/2 of a first horizontal width (D1) of an upper portion of the first through hole (210H) provided in the first insulating layer (210). For example, the first horizontal length (L1) of the extension portion (255P) of the first metal layer (255) may be less than 1/4 of the first horizontal width (D1) of the upper portion of the first through hole (210H).

In addition, the extension portion (255P) of the first metal layer (255) may extend in a horizontal direction from the upper surface of the first insulating layer (210) into the first through hole (210H). Accordingly, the extension portion (255P) of the first metal layer (255) of the embodiment may be distinguished from a protrusion or an extension portion in which a via portion or a through electrode positioned inside the through hole partially protrudes toward an inner wall of the through hole.

According to the embodiment, there is a feature that a through hole may be formed in an insulating layer while partially removing a copper foil without a photo process in a process of forming a circuit layer using a copper clad laminate. Accordingly, since a photo process conventionally required for partially removing the copper foil in forming a through electrode of the copper clad laminate is omitted, a process production delivery L/T (Lead Time) may be shortened and manufacturing cost may be reduced.

In addition, according to the embodiment, by improving plating processability in a plating process performed after forming a through hole in a copper clad laminate, physical reliability and electrical reliability of a through electrode and a circuit pattern layer (metal wiring) can be improved.

For example, since the first metal layer (255) includes the extension portion (255P) vertically overlapping at least a part of the first via portion (251v) and not contacting an inner wall of the first through hole (210H), physical reliability of a circuit layer including the first via portion (251v) can be improved.

In addition, since the extension portion (255P) of the first metal layer includes the side surface roughness (255R), plating processability in a plating process can be improved, and physical reliability and electrical reliability of a through electrode and a wiring portion can be improved.

Next, FIGS. 3A to 3D are process views of a manufacturing process of the first region (A1) of the circuit board (200) according to the embodiment illustrated in FIG. 2A. Hereinafter, a manufacturing process of the circuit board (200) including the first metal layer (255) illustrated in FIG. 2A will be described with reference to FIGS. 3A to 3D.

First, as illustrated in FIG. 3A, a first insulating layer (210) to which a first base metal layer (255a) and a second base metal layer (256a) are bonded on an upper side and a lower side, respectively, is prepared. The first insulating layer (210) includes a resin (210a) and a glass fiber (210g). In addition, the first insulating layer (210) may be formed of a material including an inorganic filler and an insulating resin. In addition, the first insulating layer (210) may include prepreg, and the prepreg may have a structure in which a glass fiber layer in the form of a fabric sheet such as glass fabric is impregnated with epoxy resin. In addition, the first insulating layer (210) may include glass or plastic. In addition, the first insulating layer (210) may include reinforced or flexible plastic such as polyimide (PI), polyethylene terephthalate (PET), propylene glycol (PPG), or polycarbonate (PC), or may include sapphire.

The first base metal layer (255a) or the second base metal layer (256a) may be a conductive metal, for example, one selected from copper (Cu), silver (Ag), tin (Sn), gold (Au), nickel (Ni), and palladium (Pd), but is not limited thereto.

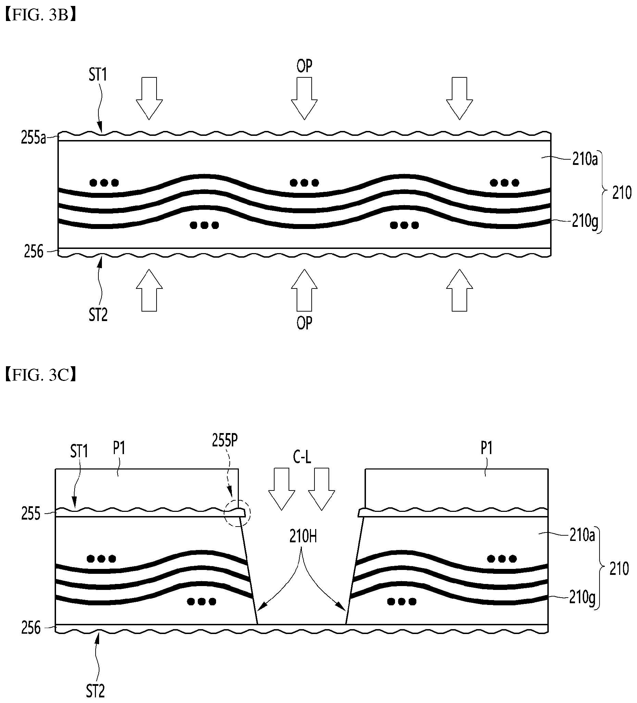

Next, as illustrated in FIG. 3B, surface treatment (OP) is performed on surfaces of the first base metal layer (255a) and the second base metal layer (256a) to form the first base metal layer (255a) including a first surface treatment region (ST1) on an upper surface and the second metal layer (256) including a second surface treatment region (ST2) on a lower surface. Since the surface treatment region may be formed on a base metal layer where a through hole is to be formed later, forming the surface treatment region on the second base metal layer (256a) may be optional.

In the embodiment, the surface treatment (OP) may maximize a laser energy absorption rate by forming roughness on a surface of the first base metal layer (255a) or the second base metal layer (256a) through a pretreatment (for example, an oxide process), and accordingly, laser drilling may be performed without etching of the metal layer at a laser processing position. In addition, formation of surface roughness by the surface treatment (OP) may be possible by an etching process on the surface of the first base metal layer (255a) or the second base metal layer (256a). For example, formation of roughness may be performed through a surface treatment process using an etchant including at least one of an organic acid, an inorganic acid, copper chloride, benzotriazole, or an alkali metal of formic acid, but is not limited thereto.

Thereafter, as illustrated in FIG. 3C, an etching mask (P1) opening a region where the first through hole (210H) is to be formed is formed, and CO₂ laser drilling (C-L) is performed to form the surface-treated first metal layer (255) and the first through hole (210H). The etching mask (P1) may be a dry film, but is not limited thereto.

In this case, the surface-treated first metal layer (255) may include an extension portion (255P) having a rough surface as if forcibly torn at a side surface of the first metal layer (255) at an entrance of the through hole (210H).

According to the embodiment, there is a feature that a through hole may be formed in an insulating layer while partially removing a copper foil without a photo process in a process of forming a circuit layer using a copper clad laminate. Accordingly, since a photo process conventionally required for partially removing the copper foil in forming a through electrode of the copper clad laminate is omitted, a process production delivery L/T (Lead Time) may be shortened and manufacturing cost may be reduced.

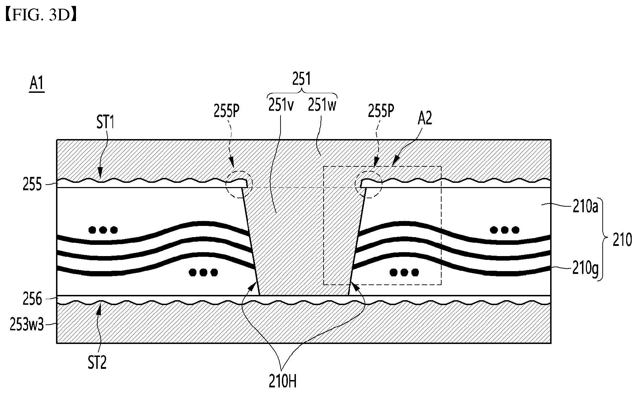

Next, as illustrated in FIG. 3D, a plating process is performed in the first through hole (210H) to form the first via portion (251v) and the first wiring portion (251w). In addition, a third wiring portion (253w) may be formed on a lower side of the second metal layer (256).

According to the embodiment, by improving plating processability in a plating process performed after forming a through hole in a copper clad laminate, physical reliability and electrical reliability of a through electrode and a circuit pattern layer (metal wiring) can be improved.

For example, since the first metal layer (255) includes an extension portion (255P) vertically overlapping at least a part of the first via portion (251v) and not contacting an inner wall of the first through hole (210H), physical reliability of a circuit layer including the first via portion (251v) can be improved.

In addition, as illustrated in FIG. 2B, since the extension portion (255P) of the first metal layer includes a side surface roughness (255R), plating processability in a plating process can be improved, and physical reliability and electrical reliability of a through electrode and a wiring portion can be improved.

Next, a semiconductor package including the circuit board according to the embodiment will be described.

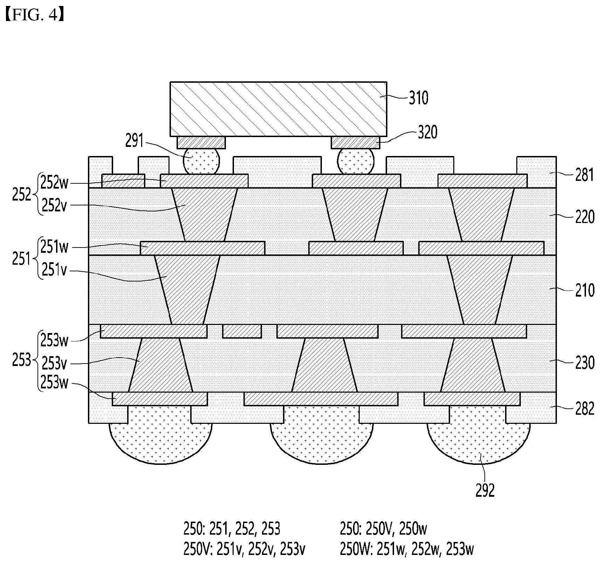

FIG. 4 is a cross-sectional view illustrating a semiconductor package according to a first embodiment, and the semiconductor package may include the circuit board (200) of FIG. 1.

Referring to FIG. 4, the semiconductor package includes a first connection portion (291), and may include a chip (310) or a device (310) disposed on the first connection portion (291).

Specifically, the second wiring portion (252w) disposed at an uppermost side of the circuit board includes a pad. The pad of the second circuit layer (252) vertically overlaps an opening of the first protective layer (281). The first connection portion (291) is disposed on the pad of the second circuit layer (252) vertically overlapping the opening of the first protective layer (281).

The first connection portion (291) may include a spherical shape. For example, a cross-section of the first connection portion (291) may include a circular shape or a semicircular shape. The first connection portion (291) may be a solder ball, but is not limited thereto.

The semiconductor package may include a chip (310) or a device (310) disposed on the first connection portion (291). The chip (310) may be a processor chip. For example, the chip (310) may be an application processor (AP) chip selected from a central processor (CPU), a graphic processor (GPU), a digital signal processor, an encryption processor, a microprocessor, and a microcontroller.

In this case, a terminal (320) may be included on a lower surface of the chip (310), and the terminal (320) may be electrically connected to the second wiring portion (252w) of the circuit board through the first connection portion (291).

Meanwhile, the semiconductor package of the first embodiment may include a plurality of chips disposed on one circuit board to be spaced apart from each other in a horizontal direction. For example, the chip (310) may include a first chip and a second chip spaced apart from each other. The first chip and the second chip may be different types of application processor (AP) chips.

Meanwhile, the semiconductor package may include a second connection portion (292). The second connection portion (292) may be disposed on a lower surface of the third circuit layer (253). For example, the third circuit layer (253) includes at least one pad. The pad of the third circuit layer (253) may vertically overlap an opening of the second protective layer (282). The second connection portion (292) may be disposed below the pad of the third circuit layer (253) vertically overlapping the opening of the second protective layer (282). The second connection portion (292) may be a solder ball, but is not limited thereto. The second connection portion (292) may be for coupling the semiconductor package and a main board (or motherboard) of an external device.

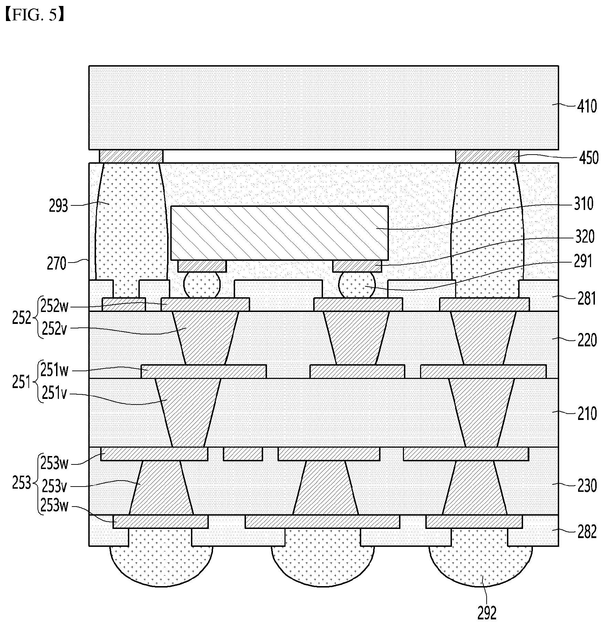

Next, FIG. 5 is a diagram illustrating a semiconductor package according to a second embodiment.

Referring to FIG. 5, an external board (410) attached on the semiconductor package of FIG. 4 according to the second embodiment is further included. The external board (410) may be an interposer, but is not limited thereto.

The external board (410) includes a plurality of insulating layers (not shown). The external board (410) includes a circuit layer (450) disposed on the plurality of insulating layers. The external board (410) may be a board connecting between a semiconductor package in which an AP chip is disposed and a semiconductor package in which a memory chip is disposed. For this purpose, the circuit layer of the external board (410) may be designed to correspond to a terminal standard of the AP chip and a terminal standard of the memory chip. Specifically, a width or a pitch of the circuit layer of a circuit board on which the AP chip is disposed may be different from a width or a pitch of the circuit layer of a circuit board on which the memory chip is disposed. Accordingly, the external board (410) may be disposed between a plurality of circuit boards having a difference in width or pitch and electrically connect them.

For this purpose, the semiconductor package further includes a third connection portion (293).

The third connection portion (293) may be disposed on the second wiring portion (252w). Specifically, the second wiring portion (252w) includes a first pad on which the chip (310) is disposed and a second pad connected to the external board (410). The third connection portion (293) may be disposed on the second pad. In this case, an uppermost end of the third connection portion (293) may be positioned higher than an upper end of the chip (310). Accordingly, in the embodiment, when coupled with the external board (410), damage to the chip (310) may be prevented.

In addition, the semiconductor package may include a first molding layer (270). The first molding layer (270) may mold the first connection portion (291), the chip (310), and the third connection portion (293). Meanwhile, although not illustrated in FIG. 5, a memory board (not shown) may be disposed on the external board (410).

### Industrial Applicability

An electronic device including the semiconductor package of the embodiment will be described. The electronic device includes a main board (not shown). The main board may be physically and/or electrically connected to various components. For example, the main board may be electrically connected to the semiconductor package of the embodiment. Various devices may be mounted on the semiconductor package.

For example, memory chips such as a volatile memory (for example, DRAM), a non-volatile memory (for example, ROM), and a flash memory, application processor chips such as a central processor (for example, CPU), a graphic processor (for example, GPU), an antenna chip, a digital signal processor, an encryption processor, a microprocessor, and a microcontroller, and logic chips such as an analog-to-digital converter and an application-specific IC (ASIC) may be mounted on the semiconductor package.

For example, at least one of various types of passive devices and active devices may be mounted on the semiconductor package.

In this case, the electronic device may be a smart phone, a personal digital assistant, a digital video camera, a digital still camera, a network system, a computer, a monitor, a tablet, a laptop, a netbook, a television, a video game, a smart watch, or an automotive device. However, the embodiment is not limited thereto, and may be any other electronic device that processes data.

Meanwhile, when the circuit board having the features of the invention described above is used in an IT device or a home appliance such as a smart phone, a server computer, or a television, functions such as signal transmission or power supply may be stably performed. For example, when the circuit board having the features of the present invention performs a function of a semiconductor package, it may protect a semiconductor chip from external moisture or contaminants, and may solve problems of leakage current, electrical short between terminals, or electrical open of terminals supplying power to the semiconductor chip. In addition, when performing a function of signal transmission, noise problems may be solved. Accordingly, the circuit board having the features of the invention described above may maintain stable functions of an IT device or a home appliance, and thus the entire product and the circuit board to which the present invention is applied may achieve functional integrity or technical linkage.

When the circuit board having the features of the invention described above is used in a transportation device such as a vehicle, distortion of a signal transmitted to the transportation device may be solved, or a semiconductor chip controlling the transportation device may be safely protected from external factors, and problems of leakage current, electrical short between terminals, or electrical open of terminals supplying power to the semiconductor chip may be solved, thereby further improving stability of the transportation device. Accordingly, the transportation device and the circuit board to which the present invention is applied may achieve functional integrity or technical linkage.

Features, structures, and effects described in the above embodiments are included in at least one embodiment of the present invention, and are not necessarily limited to only one embodiment. Furthermore, features, structures, and effects exemplified in each embodiment may be combined or modified with respect to other embodiments by those skilled in the art to which the embodiments belong. Accordingly, contents related to such combinations and modifications should be construed as being included in the scope of the present invention.

Although the embodiments have been described above with reference to specific embodiments, these are merely examples and do not limit the present invention, and those skilled in the art will appreciate that various modifications and applications not exemplified above are possible without departing from the essential characteristics of the embodiments. For example, each component specifically shown in the embodiments may be implemented in a modified manner. Differences related to such modifications and applications should be construed as being included in the scope of the present invention defined in the appended claims.

## Claims

1. A circuit board, comprising:
an insulating layer including a through hole penetrating an upper surface and a lower surface;
a circuit layer disposed on the upper surface of the insulating layer; and
a metal layer disposed between the circuit layer and the upper surface of the insulating layer,
wherein the circuit layer comprises:
a wiring portion disposed on the upper surface of the insulating layer; and
a via portion extending from the wiring portion, disposed inside the through hole of the insulating layer, and overlapping the insulating layer in a horizontal direction,
wherein the metal layer comprises an extension portion extending into the through hole, vertically overlapping at least a part of the via portion, and not contacting an inner wall of the through hole.

2. The circuit board of claim 1, wherein a side surface roughness of the extension portion of the metal layer is different from a roughness of an inner wall of the through hole formed in the insulating layer.

3. The circuit board of claim 1, wherein a horizontal length by which the extension portion of the metal layer extends into the through hole is less than 1/2 of a horizontal width of an upper portion of the through hole provided in the insulating layer.

4. The circuit board of claim 1, wherein an upper surface of the metal layer contacting the wiring portion comprises a surface treatment region.

5. The circuit board of claim 1, wherein the metal layer is disposed at a height equal to or higher than the through hole of the insulating layer.

6. The circuit board of claim 1, wherein a thickness of the wiring portion is greater than a thickness of the metal layer.

7. The circuit board of claim 1, wherein the circuit layer further comprises a second metal layer disposed on a lower surface of the insulating layer,
and the second metal layer vertically overlaps the wiring portion and the via portion.

8. The circuit board of claim 7, wherein a lower surface of the second metal layer comprises a surface treatment region.

9. The circuit board of claim 1, wherein a side inclination of the extension portion of the metal layer corresponds to an inclination of an inner wall of the through hole formed in the insulating layer.

10. A semiconductor package, comprising:
the circuit board of any one of claims 1 to 9.
